## Europäisches Patentamt

## European Patent Office

## Office européen des brevets

(11) Numéro de publication: **0 007 878**
**B1**

(12) **FASCICULE DE BREVET EUROPEEN**

(45) Date de publication du fascicule de brevet: **02.09.81**

(21) Numéro de dépôt: **79400538.9**

(22) Date de dépôt: **27.07.79**

(51) Int. Cl.³: **H 01 L 25/08, H 01 L 31/06**

(54) Générateur photovoltaique.

(30) Priorité: **02.08.78 FR 7822826**

(43) Date de publication de la demande:
**06.02.80 Bulletin 80/3**

(45) Mention de la délivrance du brevet:
**02.09.81 Bulletin 81/35**

(84) Etats Contractants Désignés:
**DE GB IT**

(56) Documents cités:
**FR - A - 2 028 840**

(73) Titulaire: **COMMISSARIAT A L'ENERGIE ATOMIQUE Etablissement de Caractère Scientifique Technique et Industriel B.P. 510 F-75752 Paris Cedex 15 (FR)**

(72) Inventeur: **Chenevas-Paule, André 42, Rue de Stalingrad F-38000 Grenoble (FR)**
Inventeur: **Melnick, Igor 43 bis, Rue Malligand F-38000 Grenoble (FR)**
Inventeur: **Vieux-Rochas, Line 5, Place de la Mairie F-38600 Fontaine (FR)**

(74) Mandataire: **Mongredien, André et al, c/o Brevatome 25, rue de Ponthieu F-75008 Paris (FR)**

Courier Press, Leamington Spa, England.

Générateur photovoltaïque

La présente invention concerne un générateur photovoltaïque. Elle s'applique à la production d'énergie électrique, à partir de rayonnements photoniques.

On sait réaliser un générateur photovoltaïque dont la structure présente une couche semiconductrice interposée entre une couche formant contact ohmique et une couche formant un contact de type Schottky. Cette structure repose sur un substrat isolant, en verre par exemple.

On sait également réaliser un générateur photovoltaïque comportant un empilement de deux ou plusieurs générateurs élementaires de type à barrière Schottky. Un tel générateur est, par exemple, decrit dans le fascicule de brevet FR - A - 2 028 840

Le semiconducteur doit avoir une épaisseur telle que du fait de son coefficient d'absorption optique, toute la lumière incidente est absorbée. Parmi ces générateurs, ceux qui seront décrits ci-après utilisent comme semiconducteur du silicium amorphe hydrogéné; on peut toutefois, utiliser dans les structures selon l'invention, d'autres semiconducteurs. Généralement, la couche métallique formant contact ohmique avec le silicium amorphe est constituée de chrome et d'antimoine. La couche supérieure qui reçoit des rayonnements photoniques incidents et qui forme un contact de type Schottky, est constituée de platine. La barrière Schottky ainsi réalisée est d'environ 0,8V.

Le principal inconvénient d'un générateur photovoltaïque présentant la structure décrite plus haut, est que le rendement de conversion photovoltaïque obtenu est de l'ordre de 5%. Cette limitation a diverses origines:
—la lumière incidente qui frappe la couche supérieure formant contact Schottky est réfléchie ou absorbée à 75% par cette couche; cet inconvénient peut être évité par l'utilisation de couche anti-reflets déposées sur cette couche Schottky. Il est cependant difficile malgré cet artifice, de faire pénétrer plus de 60% de la lumière incidente dans le semiconducteur situé en-dessous de cette couche formant contact Schottky;
—les photons créent dans le semiconducteur des paires électrons-trous; les électrons sont collectés d'une façon satisfaisante mais les trous qui présentent une longueur de diffusion faible (0,1 micron) ne sont collectés que dans la zone de charge d'espace du contact Schottky, dans le silicium amorphe. Cette zone s'étend généralement sur 0,3 micron environ.
—la résistance série entre le contact Schottky et la couche conductrice est importante; en effet, dans la zone du semiconducteur qui présente un défaut de collection des trous, la résistivité électrique est élevée.

L'invention a pour but de remédier à ces inconvénients et de réaliser un générateur photovoltaïque présentant un rendement bien supérieur à celui des générateurs photovoltaïques décrits plus haut. Il permet également de diminuer considérablement la résistance électrique série du générateur.

L'invention a pour objet un générateur photo-voltaïque comprenant un empilement photo-voltaïque de base dont la structure présente une couche semiconductrice interposée entre une couche formant contact ohmique et une couche formant un contact de type Schottky, caractérisé en ce qu'au moins un autre empilement photovoltaïque est formé sur l'empilement de base, cet autre empilement ayant une structure identique à celle de l'empilement de base et incluant l'une des couches formant contact ohmique ou Schottky, la ou les couches formant contact ohmique étant connectées entre elles, de manière à constituer une première borne de sortie du générateur et la ou les couches formant contact Schottky étant connectées entre elles de manière à constituer une deuxième borne de sortie du générateur;

Selon une autre caractéristique, les couches semiconductrices ont une même épaisseur.

Selon une caractéristique particulière, les empilements sont supportés par un substrat isolant, transparent.

Selon une caractéristique avantageuse, la première couche du premier empilement exposée à un rayonnement photonique est, de préférence, une couche transparente.

Selon une autre caractéristique de l'invention, les couches ohmiques et Schottky des différents empilements sont transparentes.

Enfin, selon une caractéristique particulière, la ou les couches formant contact Schottky sont des couches minces de platine.

D'autres caractéristiques et avantages de l'invention ressortiront mieux de la description que va suivre, donnée à titre purement illustratif, en référence aux dessins annexés, dans lesquels:
—la figure 1 représente un générateur photovoltaïque connu dans l'état de la technique;
—la figure 2 représente un premier mode de réalisation d'un générateur photovoltaïque conforme à l'invention;
—la figure 3 représente un autre mode de réalisation d'un générateur photovoltaïque conforme à l'invention;

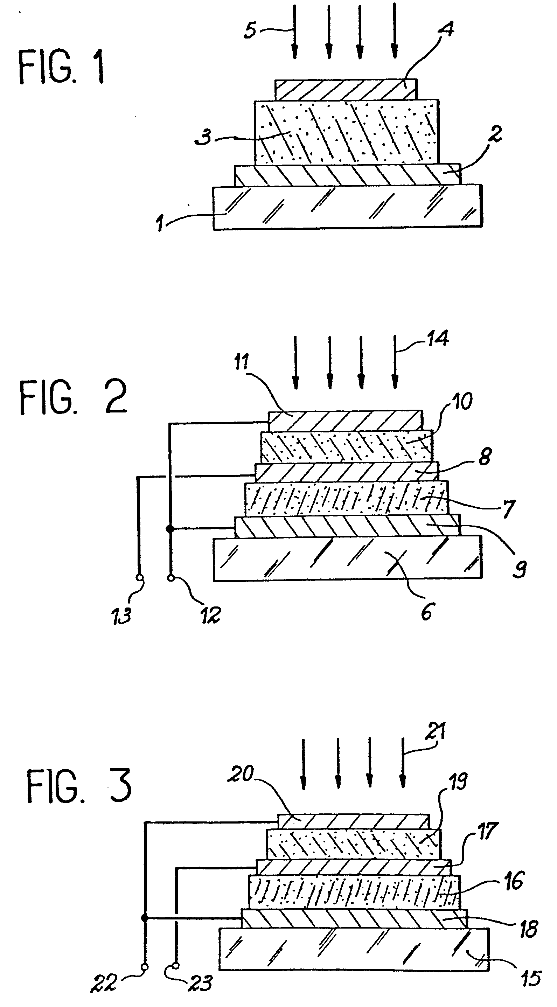

En référence à la figure 1, on a représenté un générateur photovoltaïque connu. Ce générateur comprend un substrat isolant 1, en verre par exemple, sur lequel sont déposés une ou plusieurs couches métalliques 2, présentant une bonne conductivité électrique et assurant un contact ohmique avec un semiconducteur 3, qui est lui-même déposé sur la couche 2. Sur le semi-conducteur 3 est déposée une couche mince métallique 4, suffisamment conductrice de l'électricité et transparente à la lumière; cette couche 4 assure un contact de type Schottky avec le semi-conducteur 3. La couche 2 formant un contact ohmique avec le semi-conducteur 3 peut être constituée par un revêtement de chrome d'une épaisseur de 1500 Å, recouvert d'antimoine présentant une épaisseur de 300 Å. Le semiconducteur 3 a une épaisseur telle que, compte tenu de son coefficient d'absorption optique, toute la lumière incidente 5 est absorbée. Ce semiconducteur peut être par exemple constitué par un silicium amorphe hydrogéné. La couche 4 formant contact Schottky avec le semi-conconducteur 3 peut être constituée par une couche de 150 Å d'épaisseur de platine par exemple. Cette couche donne une hauteur de barrière Schottky de 0,8 V environ, dans le semi-conducteur. Comme on l'a indiqué précédemment le rendement d'un tel générateur photovoltaïque est d'environ 5%.

En référence à la figure 2, on a représenté un premier mode de réalisation d'un générateur photovoltaïque conforme à l'invention. Ce générateur photovoltaïque comprend un substrat 6, en verre par exemple, et un empilement photovoltaïque de base dont la structure présente une couche semi-conductrice 7, interposée entre une couche 8 formant contact Schottky avec le semi-conducteur, et une couche 9 formant contact ohmique avec ce même semi-conducteur. Ce générateur comporte un autre empilement photovoltaïque formé sur cet empilement de base et présentant une structure identique à celui-ci. Cet autre empilement inclut la couche 8 qui forme contact Schottky avec le semi-conducteur 7 et qui forme aussi contact Schottky avec une autre couche semi-conductrice 10, qui est elle-même recouverte par une couche 11 formant contact ohmique avec 10. Les couches 9 et 11 formant contact ohmique respectivement avec les semiconducteurs 7 et 10, sont connectées entre elles de manière à constituer une première borne de sortie 12 du générateur photovoltaïque ainsi constitué. La couche 8 formant contact Schottky entre les semi-conducteurs 7 et 10, constitue une deuxième borne de sortie 13 de ce générateur. Les couches semi-conductrices 7 et 10 peuvent, par exemple, être constituées par un silicium amorphe hydrogéné; leur épaisseur correspond à la moitié de l'épaisseur nécessaire à l'absorption de la lumière incidente représentée en 14. Cette épaisseur, dans l'exemple de réalisation décrit, peut être de 0,5 micron environ. La couche 8 formant contact Schottky entre les deux couches semi-conductrices 7 et 10 a une épaisseur de 150 Å environ; elle peut être constituée de platine. Il est bien évident que les couches semi-conductrices 7 et 10 peuvent avoir des propriétés identiques, ou légèrement différentes, de manière à optimiser le rendement global du générateur. La couche 9 peut être une couche métallique. Il faut que la couche 11 soit transparente, par exemple une couche formée d'un mélange d'oxyde d'indium et d'oxyde d'antimoine $(In_2O_3—SbO_2)$ de quelques milliers d'Angströms au moins, 5000Å par exemple. Les deux couches conductrices formant contact ohmique 9 et 11, sont réunies de manière à constituer une première borne de sortie du générateur tandis que l'autre borne de sortie est constituée par la couche formant contact Schottky; on obtient ainsi deux diodes qui sont disposées optiquement en série et éléctriquement en parallèle.

Le générateur photovoltaïque conforme à l'invention et qui vient d'être décrit en référence à la figure 2, fonctionne de la manière suivante: 90% environ des photons incidents pénètrent dans la couche semi-conductrice 10 et ceux qui ne sont pas absorbés par cette couche sont réfléchis par le contact Schottky 8 et reviennent dans le semi-conducteur 10, où ils sont absorbés. Les photons non absorbés par la couche 10 peuvent également être absorbés par le contact Schottky 8, ou être transmis à la couche semi-conductrice 7 dans laquelle ils sont absorbés.

Le nombre de photons absorbés par les couches semi-conductrices 7 et 10 est considérablement augmenté par rapport au dispositif photovoltaïque connu dans l'état de la technique et décrit plus haut. Le rendement du générateur conforme à l'invention est donc bien meilleur.

La zone de charge d'espace créée par le contact Schottky 8 dans les semi-conducteurs 7 et 10 s'étend sur 0,3 micron environ, de part et d'autre de ce contact. Il en résulte que, par rapport aux dispositifs photovoltaïques connus, la zone de collection des porteurs minoritaires est doublée. La résistance électrique série du générateur est fortement diminuée (plus de 75%) et le rendement photoélectrique est considérablement augmenté. Il est bien évident que le nombre d'empilements qui présentent une structure identique a été limité à deux sur la figure, mais que ce nombre pourrait être accru en fonction de l'intensité des rayonnements incidents ainsi que de l'absorption des différentes couches du générateur.

En référence à la figure 3, on a représenté un autre mode de réalisation d'un générateur photovoltaïque conforme à l'invention. selon cet autre mode de réalisation, le générateur comprend un substrat 15, en verre par exemple, et sur ce substrat, un empilement de base constitué par une couche semi-conductrice 16, interposée entre une couche 17 formant contact ohmique avec cette couche semiconductrice, et une couche 18 formant contact Schottky avec cette couche semi-conductrice. Sur cet empilement de base est formé un autre empilement présentant la même structure mais incluant la couche conductrice 17, qui forme contact ohmique avec une autre couche semiconductrice 19, recouverte par une couche 20 formant contact Schottky avec cette couche 19. Les épaisseurs et la constitution des différentes couches sont semblables aux épaisseurs et à la constitution des couches du générateur décrit sur la figure 2. La couche intermédiaire 17 formant contact ohmique entre les deux couches semi-conductrices 16 et 19 est de préférence une couche transparente; de même, la couche 20 formant contact Schottky avec le semi-conducteur 19 est une couche transparente au rayonnement 21. Les couches 18 et 20 formant contact Schottky avec les semi-conducteurs 16 et 19 sont connectées entre elles de manière à constituer une première borne de sortie 22 du générateur photovoltaïque; la couche intermédiaire 17 formant contact ohmique avec les deux couches semi-conductrices 16 et 19 constitue la deuxième borne de sortie de ce générateur. Il est bien évident que le nombre d'empilements de même structure a été limité à deux sur cette figure, mais que ce nombre être plus important.

Il est à remarquer que les couches semi-conductrices de chaque diode peuvent présenter des absorptions différentes, ce qui améliore le rendement du générateur. La couche semi-conductrice de la diode superficielle, située du côté de la lumière incidente, peut présenter une absorption plus grande que celle de la deuxième diode; ainsi, les photons de haute énergie sont absorbés par la diode superficielle, tandis que les photons de faible énergie sont absorbés dans la diode profonde. Ceci peut être réalisé en utilisant deux semiconducteurs en silicium amorphe dopé à l'hydrogène, avec deux concentrations différentes d'hydrogène. On peut également utiliser un semiconducteur en silicium amorphe pour la diode superficielle et un alliage de silicium-germanium pour la couche semi-conductrice de la diode profonde.

Il est bien évident aussi que pour les deux modes de réalisation décrits, dans le cas où le nombre d'empilements est plus important, toutes les couches formant contact Schottky son connectées entre elles de manière à constituer une première borne de sortie du générateur, et toutes les couches formant contact ohmique sont connectées entre elles de manière à constituer la deuxième borne de sortie du générateur.

L'invention permet bien d'atteindre les buts mentionnés plus haut: le rendement du générateur conforme à l'invention est bien supérieur à celui du générateur à barrière Schottky décrit en page 1; de plus, les connexions électriques des différentes couches permettent de diminuer considérablement la résistance électrique série générateur photovoltaïque.

**Revendications**

1. Générateur photovoltaïque comprenant un empilement photovoltaïque de base dont la structure présente une couche semi-conductrice interposée entre une couche formant contact ohmique et une couche formant un contact de type Schottky, caractérisé en ce qu'au moins un autre empilement photovoltaïque est formé sur l'empilement de base, cet autre empilement ayant une structure identique à celle de l'empilement de base et incluant l'une des couches formant contact ohmique ou Schottky, la ou les couches formant contact ohmique étant connectées entre elles, de manière à constituer une première borne de sortie du générateur et la ou les couches formant contact Schottky étant connectées entre elles de manière à constituer une deuxième borne de sortie du générateur.

2. Générateur photovoltaïque selon la revendication 1, caractérisé en ce que les couches semi-conductrices ont une même épaisseur.

3. Générateur photovoltaïque selon la revendication 1, caractérisé en ce que les empilements sont supportés par un substrat isolant.

4. Générateur photovoltaïque selon la revendication 3, caractérisé en ce que le substrat isolant est transparent.

5. Générateur photovoltaïque selon la revendication 1, caractérisé en ce que la première couche du premier empilement exposé à un rayonnement photonique, est de préférence une couche transparente.

6. Générateur photovoltaïque selon la revendication 1, caractérisé en ce que les couches ohmiques et Schottky des empilements sont transparentes.

7. Générateur photovoltaïque selon la revendication 1, caractérisé en ce que la ou les couches formant contact Schottky sont des couches minces de platine.

**Patentansprüche**

1. Fotogalvanischer Generator mit einer fotogalvanischen Grundschichtanordnung, deren Aufbau eine Halbleiterschicht aufweist, welche zwischen einer einen Ohm'schen Kontakt bildenden und einer einen Kontakt vom Typ Schottky bildenden Schicht angeordnet ist, dadurch gekennzeichnet, daß mindestens eine andere fotogalvanische Schichtanordnung auf der Grundschichtanordnung ausgebildet ist, daß diese andere Schichtanordnung eine mit der Grundschichtanordnung identische Struktur aufweist und eine der Schichten, die den Ohm'schen Kontakt oder den Kontakt von der Art Schottky bilden, einschließt, wobei die Schicht oder die Schichten, die den Ohm'schen Kontakt bildet bzw. bilden, miteinander derart verbunden sind, daß sie einen ersten Ausgangsanschluß des Generators bilden, und daß die Schicht oder Schichten, welche den Kontakt Schottky bilden, miteinander derart verbunden sind, daß sie einen zweiten Ausgangsanschluß des Generators bilden.

2. Fotogalvanischer Generator nach Anspruch 1, dadurch gekennzeichnet, daß die Halbleitschichten die gleiche Dicke aufweisen.

3. Fotogalvanischer Generator nach Anspruch 1, dadurch gekennzeichnet, daß die Schichtanordnungen von einem isolierenden Substrat getragen sind.

4. Fotogalvanischer Generator nach Anspruch 3, dadurch gekennzeichnet, daß das isolierende Substrat transparent ist.

5. Fotogalvanischer Generator nach Anspruch 1, dadurch gekennzeichnet, daß die erste Schicht der Schichtanordnung, die einer Photonenstrahlung aussetzbar ist, vorzugsweise eine transparente Schicht ist.

6. Fotogalvanischer Generator nach Anspruch 1, dadurch gekennzeichnet, daß die Ohm'schen Schichten und die Scottky-Schichten der Schichtanordnung transparent sind.

7. Fotogalvanischer Generator nach Anspruch 1, dadurch gekennzeichnet, daß die Schicht oder die Schichten, die den Schottky-Kontakt bilden, dünne Platinschichten sind.

## Claims

1. Photovoltaic Generator comprising a basic photovoltaic stack whose structure includes a semi-conductor layer sandwiched between a layer in ohmic contact therewith and a layer in Schottky contact therewith, characterized in that at least one other photovoltaic stack is formed on the basic stack, said other stack having a structure identical to that of the basic stack and including one of the layers providing ohmic or Schottky contact, the layer or layers providing ohmic contact being interconnected to provide a first terminal for the generator, and the layer or layers providing Schottky contact being interconnected to provide a second terminal for the generator.

2. Photovoltaic Generator according to Claim 1 characterized in that the semiconductor layers have the same thickness.

3. Photovoltaic Generator according to Claim 1 characterized in that the stacks are supported by an insulating substrate.

4. Photovoltaic Generator according to Claim 3 characterized in that the insulating substrate is transparent.

5. Photovoltaic Generator according to Claim 1 characterized in that the first layer of the first stack exposed to photonic radiation is preferably a transparent layer.

6. Photovoltaic Generator according to Claim 1 characterized in that the layers of the stacks providing ohmic and Schottky contact are transparent.

7. Photovoltaic Generator according to Claim 1 characterized in that the layer or layers providing Schottky contact are thin platinum layers.

0 007 878

FIG. 1

FIG. 2

FIG. 3